**Europäisches Patentamt**

**European Patent Office**

**Office européen des brevets**

(19)

(11) Publication number : **0 582 444 A1**

(12) **EUROPEAN PATENT APPLICATION**

(21) Application number : **93306021.2**

(22) Date of filing : **30.07.93**

(51) Int. Cl.⁵ : **C23C 16/32,** C23C 16/44, C04B 35/56

(30) Priority : **31.07.92 US 923077**
**13.10.92 US 959880**
**23.11.92 US 979965**
**06.05.93 US 58608**

(43) Date of publication of application :
**09.02.94 Bulletin 94/06**

(84) Designated Contracting States :
**CH DE FR GB IT LI NL**

(71) Applicant : **CVD INCORPORATED**
**185 New Boston Street**
**Woburn Massachusetts 01801 (US)**

(72) Inventor : **Pickering, Michael A.**
**246 Willard Street Dracut**
**Massachusetts 01826 (US)**
Inventor : **Haigis, William R.**
**39 Wilshire Circle Dracut**
**Massachusetts 01826 (US)**
Inventor : **Goela, Jitendra S.**
**12 Messina Drive Andover**
**Massachusetts 01810 (US)**
Inventor : **Burns, Lee E.**
**23 Berkeley Street Reading**
**Massachusetts 01867 (US)**

(74) Representative : **Bankes, Stephen Charles**
**Digby et al**
**BARON & WARREN 18 South End Kensington**
**London W8 5BU (GB)**

(54) **Ultra pure silicon carbide and high temperature semiconductor processing equipment made therefrom.**

(57) Bulk, free-standing SiC is produced by chemical vapor deposition (CVD) having a total impurity content of 5 ppm or less by weight, preferably less than 3.5 ppm. Impurity elements, $A\ell$, As, B, Ca, Cd, Cr, Cu, Fe, K, Li, Mg, Mn, Na, Ni, P, Sb, Ti and Zr are measured by glow discharge mass spectroscopy. The deposition process is performed under carefully controlled conditions and utilizing special measures or techniques for controlling the $O_2$ content of the $H_2$ used in the CVD and keeping the deposition chamber free of particulate matter. The SiC produced is particularly suitable for applications where high purity is desired, such as high temperature semiconductor processing furnace furniture (e.g. wafer boats, process tubes, cantilever paddles or rods, and dummy wafers) and semiconductor wafer handling equipment (e.g. susceptors, vacuum chucks and transport rings).

FIG. I

The present invention is directed to ultra or very high purity, monolithic, free-standing silicon carbide which is produced by chemical vapor deposition under very carefully controlled conditions, and applications of such CVD-SiC for various high temperature semiconductor processing equipment, particularly furnace furniture (e.g. wafer boats, process tubes, cantilever paddles or rods, and dummy wafers) and wafer handling equipment (e.g. susceptors, vacuum chucks and transport rings).

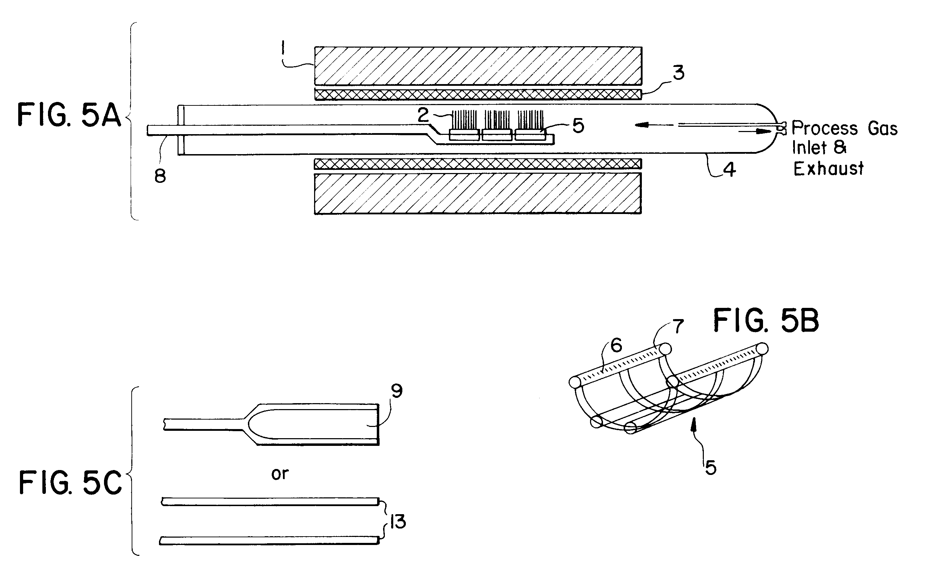

Various structural supports and equipment for handling wafers (e.g. silicon) are required during treatment at elevated temperatures to manufacture such semiconductor devices as diodes, transistors and integrated circuits. During such operations as oxidation, diffusion and deposition of various elements (e.g. metals) on or into the surface of the wafers, the wafers are typically heated to elevated temperatures up to about 1350°C. The stock material of choice from which to fabricate various semiconductor processing furnace furniture and wafer handling equipment would possess excellent thermal shock resistance, high mechanical strength, the ability to retain its shape through a large number of heating and cooling cycles (thermal stability) and the material must not outgas, i.e. release impurities (dust-like particles) during loading, processing and unloading of the wafers in the furnace. Finally the material needs to be impervious to gases and provide a good barrier to contaminants (outside environment) to prevent diffusion through the furnace liner and process tube into the furnace interior. Cleanliness and control of impurities is the single most important parameter to the achievement of the ultimate desired electrical performance in semiconductor devices. High temperature semiconductor diffusion furnaces used in the processing of silicon (Si) wafers to make semiconductor devices (see Fig. 5A-5C schematic) typically have (1) a furnace liner which is made of quartz, reaction-bonded (RB) or reaction-sintered SiC with a thin CVD-SiC coating, or graphite coated with CVD-SiC, (2) a process tube made of quartz or RB-SiC coated with CVD-SiC, (3) wafer boats made of quartz, RB-SiC coated with CVD-SiC or graphite coated with CVD-SiC and (4) a cantilever system onto which the boats are mounted and inserted into the furnace. The cantilever system uses either a paddle or rods onto which the boats "sit" during loading, processing and unloading. See, for example, U.S. Pat. No. 4,516,897. The paddles and rods are typically made of quartz or RB-SiC coated with CVD-SiC. The wafer boat may be fully loaded with the Si wafers to be treated. However, should any wafer slots in the boats be unfilled or should various monitoring or test functions be required, then dummy (false or imitation) wafers may be used as fillers or product wafer substitutes. Such dummy wafers are usually made of high purity material, such as quartz or SiC.

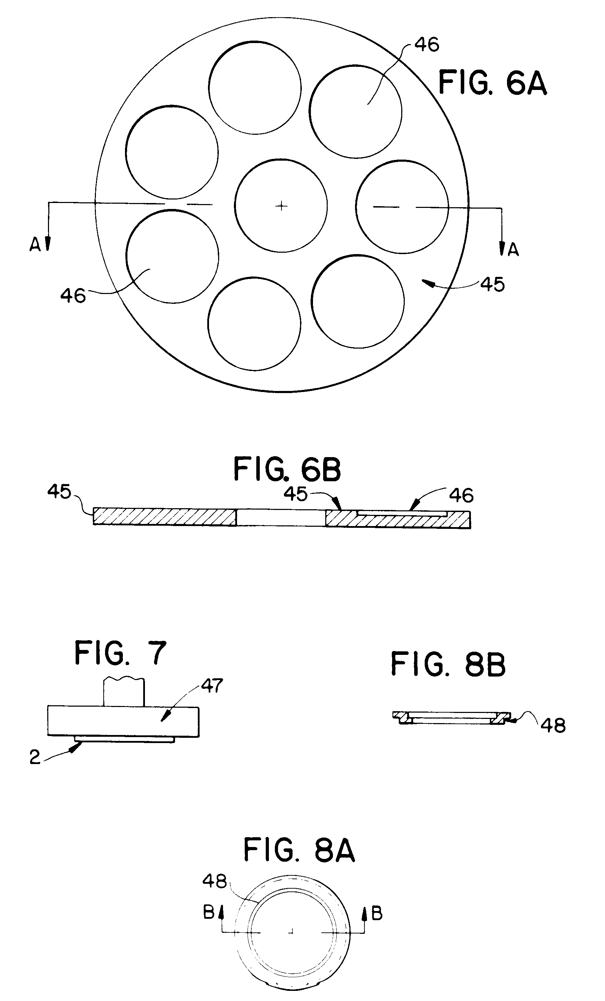

Also various high temperature semiconductor wafer handling equipment, including susceptors, vacuum chucks and transport rings, are typically used to load, unload and hold wafers in the diffusion furnace described. Susceptor plates (see Fig. 6A and 6B schematic) are typically made of graphite coated with CVD-SiC. Vacuum chucks (see Fig. 7 schematic) and, in particular, the suction heads thereof are usually made of stainless steel and other metals, as well as such ceramics as aluminum oxide ($Al_2O_3$) and SiC. Such suction heads are usually perforated to allow a vacuum to be established across their faces. See, for example, U.S. Pat. No. 4,906,011. Transport rings (see Fig. 8A and 8B schematic) are currently made of quartz and such ceramics as $Al_2O_3$ and SiC. Such wafer handling equipment is often made of quartz glass (fused silica) because of its high purity, relatively low cost and ease of fabrication into the desired shapes. However, the quartz components lose their mechanical strength and devitrify with time at the high processing temperatures involved. In addition, the quartz components are susceptible to extreme distortion (change in shape or dimensions) from frequent heating and cooling of the material during the wafer processing involved, and the quartz also does not stand up well to the frequent cleaning with such solutions as hydrofluoric/nitric acid required to maintain the ultra pure furnace environment desired. Because of these shortcomings, such alternative materials as SiC have been developed.

SiC has been shown to be an excellent choice, especially for semiconductor processing furnace furniture. See, for example, U.S. Pat. Nos. 4,761,134; 4,998,879 and 4,999,228. Such known composite furniture components consist of RB-SiC coated with CVD-SiC or graphite coated with CVD-SiC. Both the RB-SiC and graphite substrates are highly impure, containing numerous contaminants detrimental to quality semiconductor device fabrication. To help overcome this problem the substrates are coated with a thin layer of CVD-SiC which provides a diffusion barrier to prevent contaminants in the substrate material (RB-SiC or graphite) from outgassing in the semiconductor processing furnace. However, coating these substrate materials with CVD-SiC still produces a composite with impurity levels too high and substantially higher than quartz. Another problem with these CVD-SiC coated composites is that the substrates can outgas through cracks and pin-holes in the CVD-SiC coating, as well as diffuse through areas where the coating may be very thin.

It is also known to produce monolithic, free-standing CVD-SiC, for example, in bulk and in the shape of rods, tubes, etc., which are particularly useful in chemical apparatus, including semiconductor furniture, having atmospheres where high temperature and/or chemical inertness are desirable properties. See, for example, U.S. Pat. Nos. 3,157,541; 3,350,182; 3,686,378; 3,746,496; 3,853,974; 3,943,218; 3,950,479 and 3,961,003. Also of interest is U.S. Pat No. 4,488,920 showing the production of monolithic, free-standing CVD-SiC plate-like structures for use as heat exchange components, and U.S. Pat. No. 4,861,533 showing a similarly produced tubular CVD-SiC structure for use in ball bonding tools. None of these patents produces the ultra high purity CVD-SiC sought by and produced according to the present invention.

Currently the most pure form of SiC is deposited by CVD from a gas mixture of methyltrichlosilane (MTS), hydrogen ($H_2$), and generally an inert or non-reactive gas, such as argon, helium or nitrogen, argon being preferred. Monolithic, free-standing SiC is typically made by providing a furnace having a deposition chamber and a removable mandrel (e.g. graphite) therein, and pyrolytically depositing SiC from the gaseous mixture on the removable mandrel. MTS provides both Si and C in stoichiometric (1:1) ratios. The $H_2$ scavenges chlorine (Cl), producing HCl. The inert or non-reactive gas acts as a carrier gas for MTS (which is liquid at ambient temperatures); can be varied to adjust the gas flow velocity through the furnace as is necessary to sweep reaction products, such as HCl, from the SiC being deposited; and acts as a system diluent, preventing undesirable gas-phase reactions which might introduce impurities into the deposited SiC. Illustrative of such a CVD-SiC system is U.S. Pat. Nos. 4,990,374; 4,997,678 and 5,071,596.

## SUMMARY OF THE INVENTION

In accordance with the invention, ultra high purity, monolithic (bulk), free-standing SiC is produced by CVD under very carefully controlled conditions. The CVD-SiC produced has a total impurity level (i.e. the sum of all the metal, metalloid and non-metal elements shown in Table 1) of about 5 ppm or less, preferably about 3.5 ppm or less, by weight as measured by glow discharge mass spectroscopy (GDMS).

The ultra high purity, bulk SiC is preferably produced utilizing the CVD process system as disclosed in aforementioned parent applications Serial Nos. 07/923,077 and 959,880 incorporated herein.

The bulk, high purity SiC produced is particularly suitable for such high temperature semiconductor processing applications as furnace furniture and wafer handling equipment. Preferred furnace furniture items include wafer boats, process tubes, cantilever paddles or rods and dummy wafers. Preferred wafer handling equipment includes susceptors, vacuum chucks and transport rings.

## BRIEF DESCRIPTION OF THE DRAWINGS

FIG. 1 is a diagrammatic cross-sectional view of a furnace used to produce CVD-SiC in accordance with the method of the present invention.

FIG. 2 is an enlarged diagrammatic cross-sectional view of an injector nozzle extending to the deposition chamber of the furnace of FIG. 1.

FIG. 3 is a further enlarged diagrammatic cross-sectional view of the injector nozzle of FIG. 2.

FIG. 4 is a diagrammatic illustration of apparatus used in the hydrogen feed line to provide substantially oxygen-free hydrogen to the furnace of FIG. 1.

FIG. 5A is a schematic illustration of a typical semiconductor diffusion furnace.

FIG. 5B is an enlarged schematic view of the wafer boat furniture used in the FIG. 5A furnace.

FIG. 5C is an enlarged view of the cantilever paddle or rod-type furniture used in the FIG. 5A furnace.

FIG. 6A is a top schematic view of a typical pancake susceptor for handling semiconductor wafers.

FIG. 6B is a cross-sectional view of the susceptor through plane A-A of FIG. 6A.

FIG. 7 is a schematic illustration of a typical vacuum chuck for handling semiconductor wafers.

FIG. 8A is a top schematic view of a typical transport ring for handling semiconductor wafers.

FIG. 8B is a cross-sectional view of the transport ring through plane B-B of FIG. 8A.

## DETAILED DESCRIPTION OF THE INVENTION

The present invention provides ultra pure SiC having a total impurity level of about 5 ppm or less, preferably less than about 3.5 ppm, by weight as measured by glow discharge mass spectroscopy (GDMS). The total impurity level constitutes the sum of all the metal, metalloid and non-metal elements shown in Table 1 below; namely, aluminum (Al), arsenic (As), boron (B), calcium (Ca), cadmium (Cd), chromium (Cr), copper (Cu), iron (Fe), potassium (K), lithium (Li), magnesium (Mg), manganese (Mn), sodium (Na), nickel (Ni), phosphorus (P), antimony (Sb), titanium (Ti) and zirconium (Zr). Within the semiconductor processing community GDMS is widely accepted as the most reliable technique to measure the impurity content of a stock material.

Besides having significantly improved purity, the SiC produced according to the invention is stoichiometric (1:1 Si:C ratio), has a cubic ($\beta$) polycrystalline structure, is 100% theoretically dense, has very high thermal conductivity, high strength, excellent thermal shock resistance and excellent thermal stability.

Thermal conductivity is strongly dependent on the grain size and purity of the SiC, i.e., the thermal conductivity increases with increasing grain size and low impurity concentration along the grain boundaries. The grain size and, therefore, the thermal conductivity, is controlled, for example, by the deposition temperature, pressure, and gas flow rates. For example, under conditions of high temperature and low MTS flow rate (which results in low MTS partial pressure), the grain size increases. Conversely, as the temperature is lowered and the MTS flow increases, the grain size decreases. SiC produced in accordance with the invention has a thermal conductivity of about 300 W/mK or above.

According to the invention the SiC can be produced in various free-standing sizes and shapes, having particular application for high temperature semiconductor processing equipment, e.g. furnace furniture and semiconductor wafer handling components, and does not need to be coated, laminated, etc, with other materials. Herein SiC is pyrolytically produced by chemical vapor deposition (CVD) in the form of free-standing, bulk bodies of such a purity not heretofore achievable using very specific and controlled process conditions. Certain parameters, such as individual gas flow rates may vary according to the size and design of the particular CVD furnace. It has been found, however, that such CVD-SiC structures having the aforementioned impurity level as well as a thermal conductivity of at least about 300 W/mk, is preferably pyrolytically deposited in a CVD furnace having a removable mandrel on which deposition takes place under very strict reaction conditions using the gas mixture consisting of at least methyltrichlorosilane (MTS) and $H_2$; in particular: a furnace pressure of between about 180 and about 220 torr, a deposition temperature of between about 1340 and about 1380°C, preferably between about 1340 and about 1370°C, and most preferably about 1350°C, a deposition rate of between about 1.0 and about 2.0 μm/min., and an $H_2$/MTS molar ratio of between about 4 and 10. Furthermore, $H_2$ supplied as a part of the gas stream is purified so that it contains less than about 1 part per million (ppm) $O_2$ gas by weight and various means and techniques are provided to exclude particulate contaminant material from the deposition chamber. The gas mixture almost always includes an inert gas, preferably argon, as a carrier for MTS and in an amount to adjust aerodynamic properties of the gas stream. However, it is conceivable that the process might be run using only MTS carried by $H_2$. Although these specific deposition parameters may fall within broad ranges described in aforementioned U.S. patents, it is demonstrated hereinafter, that the very specific set of deposition parameters set forth above achieve the combination of ultra high purity and high thermal conductivity not found in any deposition system shown in the prior art.

With respect to "deposition chamber temperature," what is meant herein is the temperature as determined in the deposition chamber in close proximity to the mandrel on which the silicon carbide is being deposited, although the actual mandrel temperature may be slightly different. Experience has shown that temperatures at different locations relative to, but each closely adjacent the mandrel seldom vary more than about 5°C, and it is assumed that the actual deposition temperature at the mandrel is within 10°C of the probed temperature.

Thermal conductivity is believed to be relatively consistent, regardless of method of measurement. Herein, thermal conductivity is the thermal conductivity as typically measured by flash lamp techniques.

Unless otherwise stated, all properties of SiC are measured herein at room temperature, i.e., 20-28°C (293-301°K).

Herein, the monolithic (bulk), free-standing SiC produced is preferably at least 5/1000 inch thick (0.127mm). For purposes of making high temperature semiconductor processing equipment, the SiC is preferably deposited to a thickness of at least about 1-3 mm. The SiC body or structure may be partially configured according to the particular mandrel on which SiC is deposited, but is generally further configured and/or finished by machine tooling following deposition. Free-standing SiC signifies a body that is capable of standing free or on its own, and is to be distinguished from SiC thin film coatings (currently its most common application) which are required to be supported by and inseparable from a backing material or layer. Thus free-standing SiC is capable of being handled or manipulated without a backing support for such subsequent processing as machining and polishing, if required, in much the same fashion as RB or sintered castings of SiC. The SiC body may be polished on a surface or surfaces according to the requirements of the particular component part made by such conventional means as lapping using pitch and progressively finer diamond abrasive.

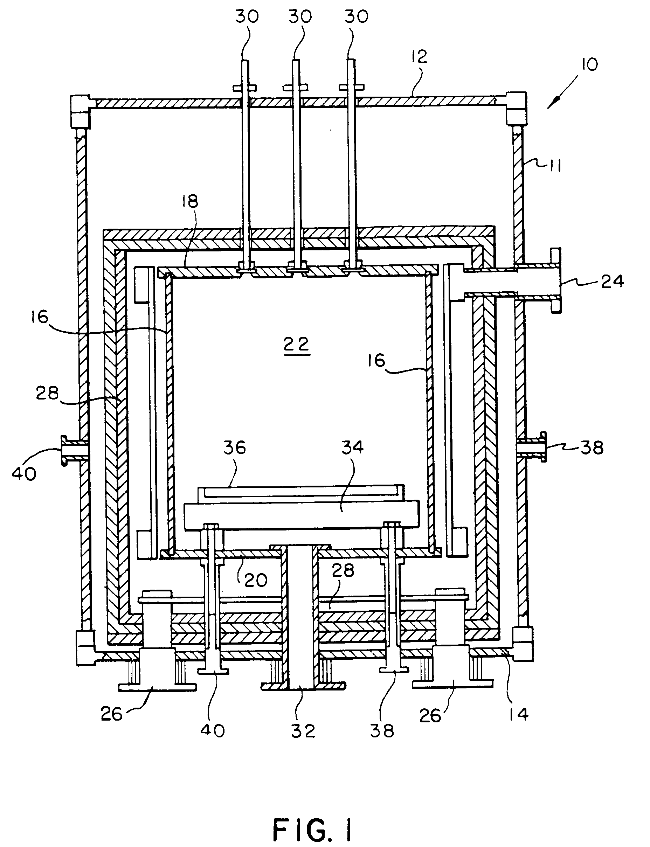

In accordance with the invention, to achieve the aforementioned degree of purity and high thermal conductivity, it has been found necessary to substantially exclude from the deposition chamber both oxygen, which tends to cause deposition of carbon inclusions, and particulates, which may become inclusions in the deposited CVD. The main source of oxygen is generally the hydrogen gas, and means and techniques are utilized to reduce and maintain the presence of oxygen in the hydrogen gas stream to less than about 1 ppm. Likewise, means and techniques are utilized for maintaining the deposition chamber substantially free of particulates or other possible inclusions. An exemplary approach to substantially eliminating oxygen and particulates is described below with respect to Figs. 1-4. It is to be understood that other techniques and means may be employed to eliminate oxygen and particulates, depending upon the system used. These Figures only illustrate those portions of the system which are modified for reducing particulates, as general CVD systems for depositing silicon carbide are well known, (see aforementioned patents).

Illustrated in Fig. 1 is a diagrammatic cross-sectional illustration of a 0.5-m CVD-SiC furnace 10 adapted for depositing ultra pure, highly thermal conductive SiC according to the invention. The apparatus includes an outer wall or housing comprising a cylindrical sidewall 11, a top plate 12 and a bottom plate 14. An inner wall or housing comprises a cylindrical sidewall (or isolation tube) 16, a top cover 18 and a bottom cover 20; the inner wall defines the inner space which is the deposition chamber 22. Surrounding the isolation tube 16 is a side heater 24; below the bottom cover 20 is a bottom heater 26. Each of the heaters 24, 26 are of the electrical resistive type, e.g., being formed of graphite glow bars.

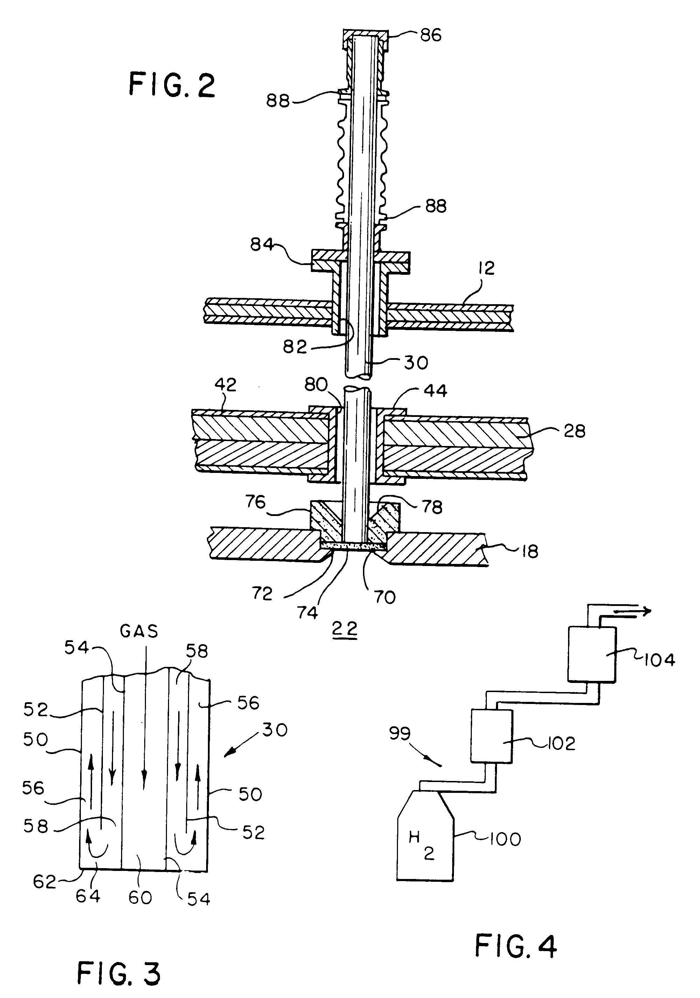

Interposed between the inner housing and outer housing and surrounding the inner housing and heaters 24, 26 are layers of insulating material 28 which are usually formed of fibrous material, e.g., carbon fibers. As will be explained in greater detail in respect to Fig. 2, these carbon fiber layers 28 are a source of particulate material, for example, during furnace assembly; and means are provided for blocking the carbon fibers as a source of particulate material, for example, during furnace assembly; and means are provided for blocking the carbon fibers as a source of particulate material to the deposition chamber. Injector means 30 provide for entry of gas through the upper end of the furnace and to the deposition chamber. In the illustrated furnace 10, three injector tubes 30 are illustrated. As will be explained in greater detail with respect to Fig. 2, the injectors are a potential source of particulates, including relatively large particulates, and the injectors 30 in the illustrated furnace have been modified from previous injector design to eliminate the injectors 30 as a source of particulate material in the deposition chamber 22. An exhaust tube 32 communicates with the lower end of the deposition chamber 22.

In the deposition chamber 22 interposed in the flow of gas, is a baffle plate 34 which is supported just above the bottom cover 22 in a horizontal orientation. Supported above the baffle plate 34, also in a horizontal orientation, is the mandrel 36 on which the bulk CVD SiC is deposited. Deposition chamber 22 temperature is monitored by thermocouples 38 and optical pyrometers 40.

Although not illustrated in detail herein, the furnace is assembled through the bottom between each run. During assembly, there is a tendency for particulates breaking off from the carbon felt insulation 28 to contaminate the deposition chamber 22. To prevent this, protective ceramic blankets or covers 42 are provided over the carbon felt layers 28. The cover means 42 illustrated in Fig. 2 comprise cover sheets of nonporous ceramic gasket material, for example graphite, such as that sold under the tradename Graffoil, and carbon sleeves 44 capping orifices through the layers 28.

In previous furnace designs, the injectors 30 have been the source of particulate material which drops onto the mandrel 36 below the SiC being deposited thereon. As diagrammatically illustrated in Fig. 3, each injector 30 is comprised of three concentric tubes which define annular passageways 56 and 58 and a central passageway 60. The central passageway 60 is the gas passageway and is open at its lower end to communicate with the deposition chamber 22. An annular cap 62 extends between the outer and inner tubes 50,54 sealing the lower end of the annular passageways 56,58 to each other. The lower end of the middle tube 52 is spaced above the annular cap 62 to provide a gap 64 that communicates the annular passageways 56,58. A coolant, usually water, is pumped downward through the inner annular passageway 58 and returns through the outer annular passageway 56. This coolant prevents deposition from occurring in the gas flow passageway 60 in the heated region where it communicates with the deposition chamber 22 by keeping the passageway 60 below the deposition temperature.

It is to be appreciated that each injector tube 30 must be movable relative to at least the top plate or cover 12 of the outer housing or the top cover 18 of the inner housing because of the different temperatures of each of the housings and the resulting difference in expansion and contraction during furnace operation. In previous furnace designs (not shown) the lower end of the injector tubes extended downward below the top cover 18 of the inner housing and into the deposition chamber 22 to ensure continual communication between the central passage of the injector and the deposition chamber. This was found to be problematic in that the cooler injectors tended to promote condensation and film build-up thereon, which deposition might flake off and fall onto the mandrel 36 therebelow and become large particulate inclusions in the SiC being deposited thereon.

To overcome this problem, the injector tubes 30 have been positioned or adapted to extend downward to, but not into, the deposition chamber 22, providing continuous communication with the deposition chamber, while being relatively slidable relative to the top plate 12 of the outer housing. Illustrated in Fig.2 is a preferred design for injector apparatus which provides for each injector tube 30 extending to, but not into, the deposition chamber 22. An inlet opening 70 in the top cover 18 of the inner housing is shaped to provide an annular ledge 72. Seated in the opening 70 on the ledge 72 is a carbon washer 74 of appropriate interior diameter that each injection tube 30 seats thereontop. To facilitate seating of each injector tube 30 on the washer 72 during furnace assembly, a tubular carbon guide 76 having a tapered upper end 78 also is seated in the opening 70 on the washer 72. Each injector tube 30 extends upwards through openings 80, 82 in the insulation 28 and top plate 12.

It is important that the openings in the outer housing, including the opening 82, through which each injector tube 30 extends, be sealed. Accordingly, a flanged sleeve 84 is provided at the opening 82, fixed to the top plate 12. Each injector tube 30 is vertically movable through the flanged sleeve 84 to accommodate differential thermal expansion of the inner and outer housings. A coupling 86 is provided around each injector tube 30 at a location above the top plate 12. Providing a seal between the coupling 86 and the flanged sleeve 34 is a bellows 90 that accommodates relative vertical movement between the top plate 12 and each injector tube 30. To provide for disassembly and assembly, the illustrated bellows provides for attachment and separation 88 at two points; 0-rings 88 at these points provide a gas-tight seal during operation.

As discussed briefly above, another source of inclusions which detract from uniform deposition of SiC is the presence of oxygen. In examination of previous depositions, small carbon inclusions could be found. Also, it was noted in SiC depositions that bands of carbon inclusions tended to form when hydrogen cylinders were changed, indicating that oxygen might by the culprit. To avoid changing hydrogen cylinders, sufficiently large hydrogen cylinders are now being employed to supply an entire deposition run. Nevertheless, commercially available hydrogen sources tend to contain amounts of oxygen which, though very minor, are significant with respect to producing carbon inclusions in CVD-SiC. Accordingly, to produce the SiC of the present invention, it was found necessary to purify the hydrogen gas, particularly to substantially eliminate trace oxygen from the hydrogen.

Fig. 4 is a schematic of a hydrogen gas line 99 which has been modified to eliminate oxygen and some other gaseous impurities continuously from the $H_2$ introduced. The hydrogen gas line confluences with a flow of argon-carried MTS (not shown), and the combined flow of argon, hydrogen and MTS is introduced into the deposition chamber 22 through the injectors 30. The gas line includes the hydrogen source 100. Downstream from the hydrogen source 100 is a catalytic purifier 102, such as Resource Systems, Inc., Model RCP-500, which converts oxygen to water. Downstream of the catalytic purifier 102 is a molecular sieve dryer 104, such as Resource Systems, Inc., Model MSD-1000, which traps the water. This system reduces the oxygen content of the hydrogen gas stream to below 1 ppm. This system is also capable of removing carbon dioxide, ammonia and other undesirable polar molecules. Although this system represents the preferred method of removing $O_2$ from the $H_2$ gas stream, other means, such as a gettering system, could be employed for this purpose.

Fig. 5A is a schematic of a well known type high temperature diffusion furnace 1 used in the processing of wafers 2, e.g. silicon, to make semiconductor devices. The major components of this process system are: (1) furnace liner 3, (2) process tube 4, (3) wafer boats 5 and (4) cantilever system 8. The furnace liner 3 is an open ended tube which acts as a barrier to separate the process tube 4 from the diffusion furnace 1. The furnace liner 3 is usually about 65 inches long and aids in preventing diffusion of impurities which, for example, outgas from the hot furnace walls, heating elements, etc., into the process tube 4. The process tube 4 is a closed end tube, typically about 120 inches long, with gas inlet and exhaust ports at the closed end and an openable flange at the opposite end. Wafers 2 are loaded into the flanged end of the process tube, when opened, then sealed in the tube whereupon the tube is heated and gases are metered into the tube. Certain of the gaseous elements diffuse into the wafers at high temperatures to obtain the desired electrical properties, and any by-products of the process exit through the exhaust port. Wafers 2 are held inside the process tube 4 in what are known as wafer boats 5. Fig. 5B is an enlarged schematic view of a typical wafer boat as depicted in Fig. 5A. There are numerous well known boat designs, which are usually about 6 inches long; however, all of the different designs have a common feature of holding a plurality of wafers in evenly spaced slots 6 machined into the walls or rails 7 of the boats. The cantilever system 8, usually about 120 inches long, is used to load and unload the wafer boats 5 into the process tube 4. The cantilever system uses either a paddle 9 or parallel rods 13 (two per set) mounted to an end cover plate (not shown) onto which the wafer boats sit during loading, processing and unloading. Fig. 5C illustrates an enlarged view of the cantilever paddle or rods schematically depicted in Fig. 5A. The wafer boats 5 are placed on the paddle 9 or rods 13 and then slid into the process tube 4 on a rail system (not shown). The cantilever and cover plate is then sealed to the process tube flange (open end).

Fig. 6A is a top view of a well known pancake type susceptor 45 having a central opening for handling semiconductor wafers. Fig. 6B is a cross-sectional view of disc shaped susceptor plate 45 shown in Fig. 6A through plane A-A. Susceptors are typically used to heat wafers, e.g. silicon, during various processes known in the art for making semiconductor devices. A plurality of wafers are typically placed in recessed pockets 46 (seven are shown) in the susceptor plate, which is then loaded into a processing chamber (not shown), typically made of quartz. The wafers are then heated, for example, by coupling electromagnetic energy (usually RF or infrared energy) into the susceptor plate which heats the plate and wafers.

Fig. 7 is a schematic illustration of a vacuum chuck 47 for handling semiconductor wafers 2 which are frequently transported robotically from one process station to another. Ideally the vacuum chuck is perforated and made of a lightweight, stiff, high purity material, as previously indicated, that can be fabricated with an optically flat surface. Also the material should maintain its flatness after repeated heating and cooling cycles during processing.

Fig. 8A is a top schematic view of a typical transport ring 48 having a central opening for handling semiconductor wafers. A cross-sectional view through plane B-B of Fig. 8A is shown of the transport ring 48 in Fig. 8B. The transport ring is a fixture to support a wafer during processing and transport from one process station to another. The transport ring material should be highly pure to prevent contamination of the wafer during semiconductor processing, exhibit good thermal stability, be light weight and strong, and machinable to high tolerances.

As indicated above, the ultra high purity CVD-SiC produced in bulk according to the invention satisfies the above identified criteria, and it has been found to be especially applicable stock material for fabricating the above mentioned furnace furniture and wafer handling equipment in place of the prior art materials previously discussed. The benefits of such a substitution include: (1) reduction of undesirable contaminants in semiconductor devices, (2) more reliable semiconductor devices, (3) lower semiconductor processing costs and (4) improved semiconductor device performance.

As aforementioned, it has also been found that the CVD-SiC according to the invention has special application as dummy wafers in which purity is a critical requirement. At the elevated temperatures involved, various contaminants can diffuse into or onto the semiconductor product wafers during processing and adversely change their electrical and optical properties. For example, during oxide deposition on silicon, any alkali metal and iron ions would be treated as impurities and should be avoided. Similarly Group II and IV trace impurities would be considered detrimental to III-V compound semiconductors. Dummy wafers are used, for example, as filler wafers and for monitoring and test purposes. In the filler application, the empty spaces in a boat carrying product wafers may be filled with dummy (false or imitation) wafers. This is standard technique in semiconductor fabrication and is useful in maintaining proper flow dynamics inside the reaction/deposition chamber since gaps and holes in the wafer boat would adversely change the flow characteristics of the reactive/carrier gas. In the monitoring and test application, either product wafers are replaced with or empty boat spaces are filled with dummy (monitor or test) wafers. It is difficult to run measurements on product wafers as they, for example, may have multiple component layers. Whereas a dummy wafer for a particular component would enable such measurements as growth rate, film thickness, etc., to be easily read or determined.

In addition, it has been found that the CVD-SiC according to the invention has special application as sputtering targets, evaporation sources and evaporation crucibles or boats which are used in many physical vapor deposition (PVD) systems for depositing thin films and coatings.

Comparative impurity measurements performed by GDMS on CVD-SiC produced according to the invention clearly show that the overall purity of CVD-SiC is significantly superior to SiC coated components and quartz as can be seen from the following table:

## Table 1

| Comparison of trace element impurity levels (ppm by weight) measured in Norton SiC from U.S. Patent 4,998,879; General Electric (GE) Fused Quartz and the CVD–SiC according to the invention | | | | |
|---|---|---|---|---|
| Impurity | INVENTION CVD–SiC | Norton SiC U.S. Pat. 4,998,879 | GE Fused Quartz* | |
| | | | Type 214 | Type 224 LD |
| Al | <0.0091 | <10 | 14 | 14 |
| As | <0.0094 | unknown | <0.01 | <0.01 |
| B | 0.29 | <10 | <0.2 | <0.2 |
| Ca | <0.058 | 20 | 0.4 | 0.4 |
| Cd | <0.15 | unknown | <0.01 | <0.01 |
| Cr | <0.1 | 1 | 0.05 | 0.05 |
| Cu | <0.016 | 6 | <0.05 | <0.01 |
| Fe | <0.04 | 22 | 0.2 | 0.2 |
| K | <0.094 | unknown | 0.6 | <0.4 |
| Li | <0.003 | unknown | 0.6 | <0.001 |
| Mg | <0.03 | 6 | 0.1 | 0.1 |
| Mn | <0.004 | unknown | <0.05 | <0.05 |
| Na | <0.03 | 12 | 0.7 | 0.1 |
| Ni | <0.013 | 1 | <0.1 | <0.1 |
| P | 0.028 | unknown | <0.2 | <0.2 |
| Sb | <0.027 | unknown | <0.003 | <0.003 |
| Ti | <0.0042 | unknown | 1.1 | 1.1 |
| Zr | <0.0032 | unknown | 0.8 | 0.8 |
| Totals | <0.9089 | <88 | <19.173 | <17.734 |
| * Data obtained from GE Fused Quartz Products brochure, Form 7700, 5/92/5M (GE Quartz, Marketing & Sales Headquarters, 21800 Tungsten Road, Cleveland, OH 44117) | | | | |

Note the CVD-SiC according to the invention has greater than an order of magnitude (factor of 10) less trace element impurities than the GE quartz and approximately two orders of magnitude (factor of 100) less than the Norton SiC.

The CVD-SiC according to the invention has been analyzed at different testing laboratories on the same sample, and these results show that total impurity level is very low, i.e. less than about 5 ppm, and even less than 3.5 ppm, by weight. Similar results have been obtained on numerous samples from different CVD runs and different furnaces, i.e. a small research size furnace and larger 0.5-m and 1.5-m production furnaces.

The invention will now be described in greater detail by way of specific examples.

## Example 1

Conditions were optimized for a 0.5-m and a 1.5-m production furnace of Morton Advanced Materials, Woburn MA, which conditions are given in the table below. It is to be appreciated that chemical vapor deposition furnaces, as are those used in this example, are custom manufactured, and that specific conditions of flow rate may vary from furnace to furnace. To produce CVD-deposited SiC in accordance to the invention, temperature, pressure, $H_2$/MTS ratio and deposition rate should be within the ranges set forth below, regardless of specific furnace design.

| Process Parameter | 0.5-m Furnace | 1.5-m Furnace |
|---|---|---|
| Furnace Pressure (torr) | 200 | 200 |
| Deposition Temperature (°C) | 1350 | 1350 |
| Gas Flow Rates: (slpm) | | |
| $H_2$ | 28 | 140 |
| Ar | 72 | 550 |
| MTS | 5.6 | 28 |
| Gas Partial Pressures: (torr) | | |
| $H_2$ | 53 | 39 |
| Ar | 136 | 153 |
| MTS | 10.6 | 7.8 |
| Deposition Rate (um/min) | 1.5 | 1.9 |
| $H_2$/MTS Gas Flow Ratio | 5 | 5 |

## Example 2

Using the 0.5-m Furnace of Example 1, CVD-SiC is deposited in accordance with the conditions described in aforementioned U.S. Pat. No. 4,990,374, column 1, lines 30-36, i.e.: deposition temperature 1300°C, furnace pressure 200 torr, gas partial pressures Ar 68 torr, $H_2$ 102 torr and MTS 30 torr. The following table compares properties of the SiC deposited using the conditions in Example 1 with the SiC deposited in accordance with said patent. (Values specified room temperature measurement values (20-25°C).

EP 0 582 444 A1

| Property | Example 1 Conditions | 4,990,374 Cond. |
|---|---|---|
| Crystal Structure | FCC, polycrystalline | FCC, polycryst. |
| Grain Size ($\mu$m) | 17 | 8 |
| Density (g/cm$^3$) | 3.21 | 3.21 |
| Hardness (Knoop, g load) | 2500 | 2500 |
| Chemical impurities total ppm (Table 1) | <5 | Unknown |
| Flexural Strength, 4-point (MPa) | 430 | 490 |
| Elastic Modulus | 466 | Unknown |
| Coefficient of Thermal Expansion (K$^{-1}$) | $2.2 \times 10^{-6}$ | $2.2 \times 10^{-6}$ |
| Thermal Conductivity (W/mK) | >300 | 100-145 |
| Polishability (Å RMS) | <1 | ~10 |

Example 3

In a 70 hr. run, CVD-SiC was deposited in a 0.5mm furnace under the following conditions:

| | |
|---|---|
| Furnace Pressure, (torr) | 200 |
| Deposition Temperature, °C | 1350 |
| Gas Flow Rates: (slpm) | |
| $H_2$ | 28 |
| Ar | 77 |
| MTS | 5.9 |
| Gas Partial Pressures: (torr) | |
| $H_2$ | 50 |
| Ar | 139 |
| MTS | 10.6 |
| Deposition Rate, $\mu$m/min | 1.5 |
| $H_2$/MTS Gas Flow Ratio | 4.7 |

The CVD-SiC produced has a total impurity level (see Table 1) of less than about 3.5 ppm by wt. and a thermal conductivity of 304.9 W/mK at 28°C (301°K) and polishable to <1Å RMS.

## Claims

1. Ultra high purity, monolithic, free-standing chemical vapor-deposited (CVD)-SiC having a total impurity level of the elements Aℓ, As, B, Ca, Cd, Cr, Cu, Fe, K, Li, Mg, Mn, Na, Ni, P, Sb, Ti and Zr of 5 ppm or less by weight as measured by glow discharge mass spectroscopy (GDMS).

2. CVD-SiC according to claim 1 wherein the said total impurity level is less than 3.5 ppm.

3. A process for producing CVD-SiC according to claim 1 or claim 2 which comprises introducing methyltri-

10

chlorosilane (MTS) and hydrogen ($H_2$) gas into a furnace (10) containing a deposition chamber (22) having a mandrel (36) therein under conditions which pyrolytically deposit on the mandrel SiC which is subsequently removed from the mandrel, wherein said conditions comprise a deposition chamber temperature of 1340 to 1380°C, a deposition chamber pressure of 180 to 220 torr, a $H_2$/MTS molar ratio of 4:1 to 10:1, and a deposition rate of 1 to 2 $\mu$m/min, the $H_2$ gas containing less than 1 ppm by weight 02 gas, and the deposition chamber being maintained substantially free of particulate material.

4. A process according to claim 3 wherein the furnace is provided with fibrous insulation (28) lining the interior walls of the deposition chamber (22), and wherein the deposition chamber is maintained substantially free of particulate material by covering the fibrous insulation lining with a protective ceramic blanket (42).

5. A process according to claim 3 or claim 4 wherein the furnace is provided with an inner and outer containment wall defining the deposition chamber and a cooled gas injector (30) which communicates with the deposition chamber by extending through the outer containment wall (12), and wherein the deposition chamber is maintained substantially free of particulate material by positioning and maintaining the cooled gas injector at the boundary (18) of the deposition chamber.

6. A process according to any one of claims 3 to 5 wherein the $H_2$ introduced is continuously purified to maintain the $O_2$ content below 1 ppm.

7. High temperature semiconductor processing equipment made from the CVD-SiC according to claim 1 or claim 2, or from CVD-SiC made by a process according to any one of claims 4 to 6.

8. Equipment according to claim 7 comprising a dummy wafer, wafer boat, process tube, cantilever paddle or cantilever rods for use as furnace furniture.

9. Equipment according to claim 7 comprising a susceptor, vacuum chuck or transport ring for wafer handling.

FIG. 1

FIG. 2

FIG. 3

GAS

FIG. 4

EP 0 582 444 A1

FIG. 5A

1

3

2

5

8

4

Process Gas
Inlet &
Exhaust

FIG. 5B

6

7

5

FIG. 5C

9

or

13

14

FIG. 6A

46

45

A

A

46

FIG. 6B

45

45

46

FIG. 7

47

2

FIG. 8B

48

FIG. 8A

48

B

B

**European Patent Office**

**EUROPEAN SEARCH REPORT**

Application Number

EP 93 30 6021

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| Y | JOURNAL OF THE ELECTROCHEMICAL SOCIETY vol. 132, no. 3 , March 1985 , US pages 642 - 648 P. LIAW ET AL. 'EPITAXIAL GROWTH AND CHARACTERIZATION OF BETA SIC THIN FILMS' | 3,6 | C23C16/32 C23C16/44 C04B35/56 |
| A | * page 643, left column, line 43 - line 63 * | 1,2,4,5, 7-9 | |
| Y,D A,D | EP-A-0 494 753 (CVD INCORPORATED) * example 2 * | 3,6 1,2,4,5, 7-9 | |
| A | JOURNAL OF THE ELECTROCHEMICAL SOCIETY vol. 118, no. 6 , June 1971 , USA pages 1001 - 1006 JACOBSON K A 'Growth, texture, and surface morphology of SiC layers' * page 1002, left column, line 15 - line 51 * | 1-9 | |
| A | SPRINGER PROCEEDINGS IN PHYSICS, AMORPHOUS AND CRYSTALLINE SILICON CARBIDE AND RELATED MATERIALS II. vol. 43 , 16 December 1988 , BERLIN pages 198 - 206 Y. CHINONE ET AL 'APPLICATIONS OF HIGH PURITY SIC PREPARED BY CHEMICAL VAPOR DEPOSITION' * page 200 * | 1-9 | TECHNICAL FIELDS SEARCHED (Int.Cl.5) C23C C30B F27D |
| A | DATABASE WPI Derwent Publications Ltd., London, GB; AN 91-076960 Ç11 & JP-A-3 023 209 (TOYO TANSO KK) 31 January 1991 * abstract * | 4 | |

-/--

The present search report has been drawn up for all claims

| Place of search | Date of completion of the search | Examiner |
|---|---|---|
| THE HAGUE | 16 November 1993 | EKHULT, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent
Office

# EUROPEAN SEARCH REPORT

Application Number

EP 93 30 6021

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| A | US-A-4 123 989 (D.N. JEWETT)<br>* column 5, line 1 - line 48 *<br>----- | 5 | |
| | | | |
| | | | TECHNICAL FIELDS SEARCHED (Int.Cl.5) |

The present search report has been drawn up for all claims

| Place of search | Date of completion of the search | Examiner |
|---|---|---|
| THE HAGUE | 16 November 1993 | EKHULT, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)